Europäisches Patentamt

European Patent Office

Office européen des brevets

(11) Veröffentlichungsnummer: **0 237 812**
**A2**

# (12) EUROPÄISCHE PATENTANMELDUNG

(21) Anmeldenummer: 87102238.0

(22) Anmeldetag: 17.02.87

(51) Int. Cl.⁴: **H01S 3/23** , H01S 3/19

(30) Priorität: 20.03.86 DE 3609485

(43) Veröffentlichungstag der Anmeldung:
23.09.87 Patentblatt 87/39

(84) Benannte Vertragsstaaten:
DE FR GB

(71) Anmelder: **Siemens Aktiengesellschaft Berlin und München**
**Wittelsbacherplatz 2**
**D-8000 München 2(DE)**

(72) Erfinder: **Heinen, Jochen, Dr. Ing.**
**Dianastrasse 38**
**D-8031 Haar(DE)**
Erfinder: **Hanke, Christian, Dr. Ing.**
**Firlestrasse 17**
**D-8000 München 83(DE)**

(54) **Halbleiterlaser-Array mit gebündelter Abstrahlung.**

(57) Halbleiterlaser-Array, bei dem nur jede zweite - (2) der vorhandenen, miteinander optisch verkoppelten laseraktiven Streifen (2, 3) ausstrahlt, so daß nur eine (Haupt-)Strahlungskeule (50) auftritt.

FIG 2

## Halbleiterlaser-Array mit gebündelter Abstrahlung

Die vorliegende Erfindung bezieht sich auf ein Halbleiterlaser-Array mit gebündelter Abstrahlung - (Single lobe Laser) gemäß den Merkmalen des Oberbegriffes des Patentanspruches 1.

Um möglichst intensitätsstarke Laserstrahlung eines Halbleiterlasers bzw. Laserdiode zu erreichen, ist es bekannt, Halbleiter-Laserdioden als Array anzuordnen. Ein solches Array besteht aus einer Anzahl in einem Halbleiterkörper nebeneinanderliegend angeordneter, zueinander paralleler Laserdioden, wobei eine jede Laserdiode ein laseraktiver Streifen in dem Halbleiterkörper ist. Bei entsprechend dicht benachbarter Anordnung dieser laseraktiven Streifen ist wellenmechanische bzw. wellenoptische Kopplung der einzelnen laseraktiven Streifen untereinander derart wirksam, daß die einzelnen laseraktiven Streifen zueinander kohärente Strahlung aussenden, d.h. die insgesamt von dem Laser-Array abgegebene Strahlung ist in sich kohärent.

Halbleiterlaser-Arrays sind bekannt aus Appl. Phys. Letters, Bd. 42, (1983) S. 554 -556, US-4 217 561, US 4 509 173 und Electronics Letters, Bd. 21 (1985), S. 347 -349.

Diese laterale Verkopplung benachbarter laseraktiver Streifen eines Arrays neigt aber dazu, einen verkoppelten Schwingungsmodus anzuregen, bei dem ein Anteil oder sogar alle benachbarten Streifen in jeweils zueinander um 180° verschobener Phase schwingen. Die einzelnen laseraktiven Streifen senden zwar kohärente Strahlung aus, jedoch hat diese Strahlung an der Austrittsstelle auf der Stirnfläche des Halbleiterkörpers von Streifen zu Streifen entgegensetzte Phase. Entsprechend der auftretenden Interferenz ergeben sich zwangsläufig zwei Abstrahlkeulen (lobes) und je nach Anzahl der interferierenden Streifen mehr oder weniger bemerkbare Nebenmaxima. Eine solche Kopplung der Streifen untereinander mindert die Brauchbarkeit eines solchen Arrays ganz wesentlich.

Die obengenannten Druckschriften US 4 509 173 und Electronics Letters geben Maßnahmen an, mit denen bei einem Array phasengekoppelte Strahlungsaussendung erreicht werden soll. Dazu sind Maßnahmen getroffen, daß in dem Halbleiterkörper in der laseraktiven Schicht sich zueinander verzweigende und wieder zusammenführende Strahlungswege erzeugter Laserstrahlung auftreten. Solche Anordnungen haben zwangsläufig nicht parallele Weganteile der Strahlungsführung. Insbesondere bei Anordnungen nach dem Prinzip eines MCRW-Lasers ergeben sich technologische Schwierigkeiten.

Aufgabe der vorliegenden Erfindung ist es, für ein Halbleiterlaser-Array, das einen technologisch einfach herstellbaren Aufbau mit zueinander parallelen laseraktiven Streifen hat, solche Maßnahmen anzugeben, mit denen dennoch Abstrahlung mit einer einzigen Keule (single lobe) zuverlässig zu erreichen ist.

Diese Aufgabe wird mit den Merkmalen des Patentanspruches 1 gelöst und weitere Ausgestaltungen und Weiterbildungen der Erfindung gehen aus den Unteransprüchen hervor.

Bei der lateralen Verkopplung einer Anzahl n Laserstreifen zu einem Array sind grundsätzlich eine Anzahl n Schwingungs moden mit entsprechender Anzahl n Abstrahlcharakteristiken möglich. Nur der Grundmodus, bei dem alle laseraktive Streifen mit einheitlicher Phase schwingen, besitzt die gewünschte Abstrahlung in Form einer einzigen Strahlungskeule. Im allgemeinen besitzen die Schwingungsmoden unterschiedliche Schwellenbedingungen. Es wird stets der Modus mit der niedrigsten Schwelle oder eine Kombination der Moden mit ähnlich niedrigen Schwellen zum Anschwingen kommen. Beim Durchlaufen der Laserkennlinie vom Wert des Schwellenstromes zu höheren Stromwerten hin, kann der hinsichtlich seines Arbeitspunktes günstigste Modus wechseln, d.h. es können hinsichtlich der Abstrahlcharakteristik Änderungen auftreten, z.B. kann die Eigenschaft der Ausstrahlung mit nur einer einzigen Abstrahlkeule auf einen bestimmten Bereich der Stromwerte der Kennlinie begrenzt sein. Insbesondere bei vorgesehener Modulation des Arrays durch Modulation des Speisestroms kann dies sogar zu Instabilitäten bzw. dauernden Wechseln der auftretenden Schwingungsmoden führen.

Für die vorliegende Erfindung ist von der Erkenntnis ausgegangen worden, daß ein aus mehr als drei laseraktiven Streifen gleicher Art und gleichen Abstandes voneinander bestehendes Array dazu neigt, im höchsten Schwingungsmodus zu schwingen, bei dem ein jeder laseraktiver Streifen gegenüber dem (den) benachbarten laseraktiven Streifen um 180° phasenversetzt schwingt. Bei der Erfindung ist der für ein Array an sich prinzipiell unerwünschte Umstand, nämlich daß der voranstehend beschriebene Schwingungszustand des Arrays mit um 180° phasenverschoben - schwingenden Streifen insbesondere auch bis zu sehr hohen Arbeitsströmen der günstigste Schwingungszustand ist und daher sehr stabil ist, gerade mit besonderem Vorteil genutzt.

Diese für ein Array an sich unerwünschte Eigenschaft wird bei der Erfindung derart vorteilhaft ausgenutzt, daß sogar hohe Stabilität des Schwingungsverhaltens auch bei starker Modulation des Laserarrays gewährleistet ist. Bei der Erfindung ist durch Maßnahmen konstruktiver Art dafür Sorge getragen, daß nur jeder zweite laseraktive Streifen aus der Folge benachbart angeordneter laseraktiven Streifen ausstrahlen kann und der jeweils dazwischenliegende Streifen dementsprechend an der Ausstrahlung gehindert ist. Es ist aber dafür Sorge getragen, daß dieser nicht zur Ausstrahlung kommende laseraktive Streifen dennoch im vorgesehenen Modus des Laserarrays schwingt.

Das erfindungsgemäß vorgesehene Verhindern der Abstrahlung des jeweils nächsten laseraktiven Streifens wird dem Prinzip nach dadurch erreicht, daß dieser jeweils zweite laseraktive Streifen im Bereich der Stirnfläche des Halbleiterkörpers, von der aus die Abstrahlung ausgeht, an seinem Streifenende einen hochreflektierenden Bereich besitzt. Diese hohe Reflexion kann gemäß einer ersten Ausführungsform mit Hilfe jeweils eines metallischen oder eines dielektrischen (Interferenz-)Spiegels erreicht sein. Eine weitere Ausführungsform der Erfindung sieht Bragg-Reflektoren bzw. Bragg-Gitter vor, wie sie dem Prinzip nach in der Laserdioden-Technik Verwendung finden.

Die der Ausstrahlungsseite des Halbleiterkörpers des Laserarrays gegenüberliegende Stirnseite des Halbleiterkörpers, an der an sich keine Ausstrahlung vorgesehen bzw. erwünscht ist, kann insgesamt hochwertig spiegelnd reflektierend ausgeführt sein.

Für die einzelnen laseraktiven Streifen eines erfindungsgemäßen Arrays gilt, daß durch Überlappen der optischen bzw. elektromagnetischen Feldverteilungen der Felder der benachbarten Streifen miteinander Verkopplung dieser laseraktiven Streifen besteht, d.h., daß diese laseraktiven Streifen einen Energieaustausch untereinander haben. Bekannt ist dieser Effekt an sich von Oxidstreifenlasern, MCRW-Lasern (US-PS 4 352 187) IRW-Lasern, CSP-Lasern und dgl..

Ein erfindungsgemäßes Laserarray braucht nicht nur aus laseraktiven Streifen eines einzigen der voranstehend angegebenen Typen von Halbleiterlasern bestehen. Auch über die Länge eines jeweiligen laseraktiven Streifens hinweg kann der Typ des Halbleiterlasers wechseln. Von Vorteil ist dies z.B. im Hinblick darauf, daß z.B. ein Oxidstreifenlaser eine ausgesprochen starke laterale Verkopplung benachbarter laseraktiver Streifen hat, und zwar dies auch bei (z.B. gegenüber einem MCRW-Laser) relativ großem Abstand der laseraktiven Streifen voneinander. Ein MCRW-Laser zeichnet sich dagegen durch besonders große Indexführung und günstige Krümmung der Phasenfront des im laseraktiven Streifens eines MCRW-Lasers geführten Lichtes aus. Ein MCRW-Laser hat (vergleichsweise zum Oxidstreifenlaser) für ein erfindungsgemäßes Laser-Array vorteilhaftere Abstrahlcharakteristik.

Weitere Erläuterungen der Erfindung gehen aus der nachfolgenden Beschreibung zu Ausführungsbeispielen zur Erfindung hervor.

Figur 1 zeigt ein bekanntes Halbleiter-Laserarray mit benachbart angeordneten parallelen laseraktiven Streifen 2, die sich in einem Halbleiterkörper 1 befinden.

Die Figuren 2, 3 und 4 zeigen je eine Ausführungsform eines erfindungsgemäßen Lasers.

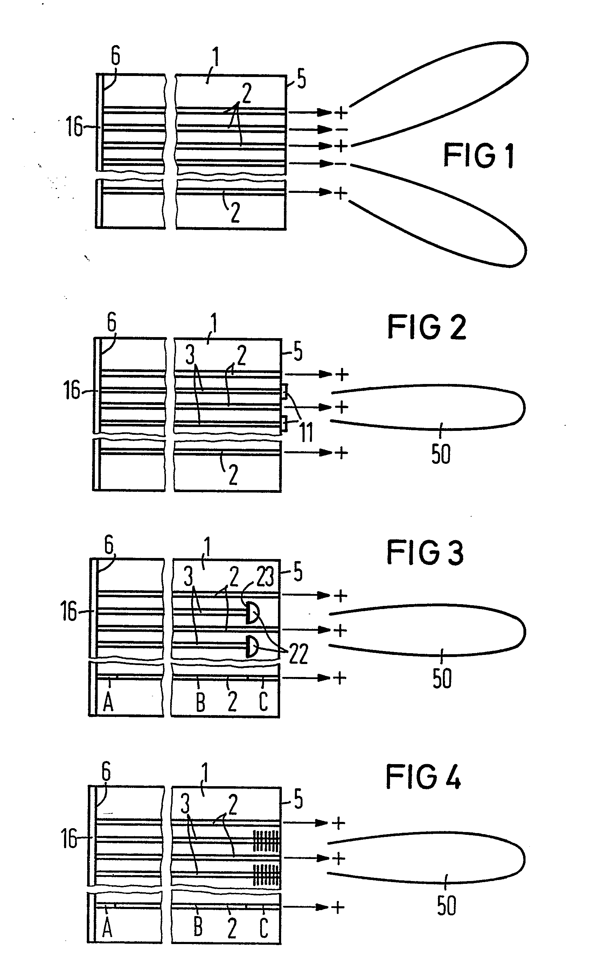

In den Figuren 2, 3 und 4 ist der Halbleiterkörper wiederum mit 1 bezeichnet. Die wie beim Array nach Figur 1 zur Ausstrahlung von Laserstrahlung vorgesehenen laser aktiven Streifen sind wiederum mit 2 bezeichnet. An der in den Figuren 2, 3 und 4 rechten Stirnseite 5 des Halbleiterkörpers 1 erfolgt die vorgesehene Abstrahlung 50 der in den laseraktiven Streifen 2 erzeugten Laserstrahlung. Die weiteren laseraktiven Streifen 3 der Ausführungsformen nach den Figuren 2, 3 und 4 können an der Stirnseite 5 erfindungsgemäß keine Laserstrahlung der laseraktiven Streifen 3 ausstrahlen.

Beim Ausführungsbeispiel der Figur 2 verhindern dies im jeweiligen Bereich eines laseraktiven Streifens 3 auf der Stirnfläche 5 vorgesehene Spiegelflächen 11. Diese Spiegelflächen sind z.B. Metallbeschichtungen, etwa aus Silber mit unterliegender transparenter Isolationsschicht, etwa $Al_2O_3$, oder auch dielektrische Spiegel - (Interferenzspiegel), die bekanntermaßen aus einer Schichtenfolge bestehen.

Beim Ausführungsbeispiel der Figur 3 wird die Ausstrahlung der Streifen 3 durch Reflektoranordnungen 21 bewirkt, die in das Material des Halbleiterkörpers 1 eingefügt angeordnet sind, wie dies z.B. in der EP-OS 0 149 042 bereits beschrieben ist. Es werden dazu von der Oberfläche des Halbleiterkörpers 1 her Gruben 22 in das Material des Halbleiterkörpers 1 hineingeätzt, wobei dies so ausgeführt ist, daß die dem jeweiligen laseraktiven Streifen 3 zugewandte Stirnseite 23 der Grube 22 eine plane Fläche ist, die für die Strahlung eines Streifens 3 reflektierend wirkt. Es kann diese Fläche 23 der Grube 22 sogar verspiegelt sein.

Beim Ausführungsbeispiel der Figur 4 ist am jeweils rechtsseitigen Ende eines jeweiligen laseraktiven Streifens 3 ein Bragg-Reflektor (DBR), wie er ebenfalls aus der Laserdioden-Technologie bekannt ist.

Bei den Ausführungsformen der Figuren 2, 3 und 4 kann die linksseitige Stirnfläche 6 des Halbleiterkörpers 1 ganz flächig spiegelnd wirksam sein, z.B. ein Spiegel 16.

In der Figur 3 ist als Beispiel (auch für die Ausführungsform nach Figur 2) an einem der laseraktiven Streifen (in Figur 3 der unterste laseraktive Streifen 2) dargestellt, wie über die Länge dieses laseraktiven Streifens 2 verteilt unterschiedliche Lateralstrukturen A, B und C vorgesehen sein können. Zum Beispiel ist es günstig, für die Lateralstruktur C den Typ eines MCRW-Lasers vorzusehen, der hinsichtlich der Indexführung der Laserstrahlung besonders vorteilhaft ist, jedoch weniger starke laterale Verkopplung aufweist, die im Bereich der Lateralstruktur C ohnehin nicht zur Wirksamkeit kommen könnte, da (wie dargestellt) die laseraktiven Streifen 3 zumindest nicht wesentlich bis in den Bereich der Lateralstruktur C der Streifen 2 hineinreichen. Vorteilhaft ist es, die Lateralstruktur B als Oxidstreifenlaser auszuführen, der typisch starke laterale Kopplung mit den benachbarten laseraktiven Streifen 3 hat. Die Lateralstruktur A kann z.B., vorzugsweise mit Rücksicht auf die Reflexion an der Stirnfläche 6, wiederum eine MCRW-Struktur sein.

Der Aufbau und die Technologie der Herstellung eines erfindungsgemäßen Halbleiterlaser-Arrays gemäß der Figur 2, der Figur 3 und gemäß weiterer Varianten des Erfindungsgedankens ist einfach bzw. wenig aufwendig, vergleichsweise zu Halbleiterlaser-Arrays mit weniger günstigen Eigenschaften, wie z.B. eines solchen nach Figur 1.

Für die vollverspiegelten laseraktiven Streifen 3 gilt, daß nur ein Teil der im Resonator befindlichen Laserstrahlungsenergie im dynamischen Gleichgewicht gespeichert wird. Ein erheblicher Anteil der erzeugten optischen Strahlungsleistung wird über die benachbarten laseraktiven Streifen 2 ausgekoppelt, die in Wechselwirkung mit den laseraktiven Streifen 3 stehen.

Halbleiterlaser-Arrays der vorliegenden Erfindung können in Halbleitermaterial ausgeführt sein, wie es üblicherweise für Halbleiterlaser verwendet wird. Bevorzugte Halbleitermaterialien sind Gallium-Aluminiumarsenid, Indium-Galliumarsenid-Phosphid, Indium-Gallium-Aluminiumarsenid, Indium-Gallium-Aluminiumphosphid, Gallium-Aluminiumantimonid und andere.

Bezugszeichenliste

1 Halbleiterkörper
2, 3 Streifen
5, 6 Stirnseite
11 Spiegelfläche
21 Grube

23 Flanke
31 Gitter
50 Strahlungskeule

## Ansprüche

1. Halbleiterlaser-Array in (auf) einem Halbleiterkörper, mit einer Folge nebeneinander angeordneter laseraktiver Streifen, **gekennzeichnet dadurch,** -daß für eine Abstrahlung mit nur einer einzigen Strahlungskeule (single lobe laser) an einer Stirnfläche (5) des Halbleiterkörpers (1), -in der Folge der laseraktiven Streifen (2, 3, 2, 3 ...) der jeweils zweite laseraktive Streife (3) im Bereich der für die Ausstrahlung bestimmten Stirnfläche (5) des Halbleiterkörpers (1) mit für die Laserstrahlung reflektierend wirkenden und Ausstrahlung verhindernden Mitteln (11, 21, 31) versehen ist.

2. Array nach Anspruch 1, **gekennzeichnet dadurch,** daß dieses reflektierende, die Ausstrahlung verhindernde Mittel eine im Bereich des jeweiligen laseraktiven Streifens (3) vorgesehene Verspiegelung (11) der Stirnfläche (5) des Halbleiterkörpers (1) ist.

3. Array nach Anspruch 1, **gekennzeichnet dadurch,** daß das reflektierende, die Ausstrahlung verhindernde Mittel eine in die Oberfläche des Halbleiterkörpers (1) im Bereich des jeweiligen laseraktiven Streifens (3) eingefügte Reflexionsfläche - (21) ist.

4. Array nach Anspruch 3, **gekennzeichnet dadurch,** daß sich die eingefügte Reflexionsfläche (21) eine Seitenwand (23) einer in dem Halbleiterkörper (1) befindlichen Grube (22) ist.

5. Array nach Anspruch 1, **gekennzeichnet dadurch,,** daß das Mittel ein im Bereich des laseraktiven Streifens (3) angeordneter Bragg-Reflektor (31) ist.

FIG 1

FIG 2

FIG 3

FIG 4